# EUROPEAN PATENT APPLICATION

(11) **EP 4 796 815 A1**
(43) Date of publication of application: **26.08.2026**
(21) Application number: 26159022.8
(22) Date of filing: 17.02.2026
(51) Int. Cl.: F16J 15/02, F16J 15/10, H01R 13/52, H02K 5/22, H05K 5/02

(54) **SEALING DEVICE AND SEALING STRUCTURE**

(30) Priority: 21.02.2025 JP 2025026897
(71) Applicant: NOK Corporation, Minato-ku Tokyo 105-8585 (JP)
(72) Inventor: KIKUCHIYA, Yuta, Aso-shi, Kumamoto, 8692231 (JP)
(74) Representative: Global IP Europe Patentanwaltskanzlei

(57) **Abstract**

A sealing device seals a gap between an inner peripheral surface of an opening in a first member and an outer surface of a second member that is stationary within the opening. The sealing device includes: a first elastic body that includes: a first outer surface in contact with an inner peripheral surface of the opening in the first member; a first opening; and a first inner surface that defines the first opening; and at least one second elastic body that is located within the first opening of the first elastic body and includes: a second outer surface that faces the first inner surface of the first elastic body with a separation space: and a second inner surface in contact with the outer surface of the second member. The first elastic body further includes a first protrusion that extends inward from the first inner surface and is in contact with the second outer surface of the at least one second elastic body.

## Description

### CROSS REFERENCE TO RELATED APPLICATION

This Application is based on and claims priority from Japanese Patent Application No. 2025-026897 filed on February 21, 2025, the entire contents of which are incorporated herein by reference.

### BACKGROUND

### TECHNICAL FIELD

This disclosure relates to a sealing device and to a sealing structure.

A variety of techniques have been proposed for sealing a gap between an inner peripheral surface of an opening in a first member and an outer surface of a second member located within the opening. For example, Japanese Patent Application Laid-Open Publication No. 2024-125089 discloses that gaps between inner peripheral surfaces of openings in a housing partition (e.g., first member) and an outer surface of motor wirings (e.g., second members) located in respective ones of the openings are sealed by deformable hollow elastic bodies that each surround portions of the motor wirings.

In one example, flat wiring members, such as bus bars, are used in an electric vehicle, and elastic bodies are attached to the flat wiring members. The elastic bodies each have obround openings that seal gaps between the flat wiring members and obround openings in which the flat wiring members are located. To minimize displacement between the wiring members and the obround openings of the elastic bodies, it is necessary to closely space the obround openings. However, it is difficult to mold an elastic body with sufficiently narrow obround openings. Although the foregoing description focuses on flat wiring members, the same problem applies to an opening in a first member through which a second member passes.

### SUMMARY

In view of the above circumstances, an object of one aspect of this disclosure is to securely seal a gap between an inner peripheral surface of an opening in a first member and an outer surface of a second member, using an elastic body, without excessively narrowing an opening in the elastic body that surrounds the second member, and to minimize displacement of the second member relative to the first member.

A sealing device, according to an aspect of this disclosure, seals a gap between an inner peripheral surface of an opening in a first member and an outer surface of a second member that is stationary within the opening. The sealing device includes: a first elastic body that includes: a first outer surface in contact with an inner peripheral surface of the opening in the first member; a first opening; and a first inner surface that defines the first opening; and at least one second elastic body that is located within the first opening of the first elastic body and includes: a second outer surface that faces the first inner surface of the first elastic body with a separation space: and a second inner surface in contact with the outer surface of the second member. The first elastic body further includes a first protrusion that extends inward from the first inner surface and is in contact with the second outer surface of the at least one second elastic body.

A sealing device, according to an aspect of this disclosure, seals a gap between an inner surface of an opening in a first member and an outer surface of a second member that is stationary within the opening. The sealing device includes: a first elastic body that includes: a first outer surface in contact with an inner peripheral surface of the opening in the first member; a first opening; and a first inner surface that defines the first opening; and at least one second elastic body that is located within the first opening and includes: a second outer surface that faces the first inner surface of the first elastic body with a separation space: and a second inner surface in contact with the outer surface of the second member. The at least one second elastic body further includes a second protrusion that extends outward from the second outer surface and is in contact with the first inner surface of the first elastic body.

A sealing structure, according to an aspect of this disclosure, includes: a first member that has an opening; a second member that is stationary within the opening; and a sealing device that seals a gap between an inner peripheral surface of the opening in the first member and an outer surface of the second member. The sealing device includes: a first elastic body that includes: a first outer surface in contact with an inner peripheral surface of the opening in the first member; a first opening; and a first inner surface that defines the first opening; and at least one second elastic body that is located within the first opening of the first elastic body and includes: a second outer surface that faces the first inner surface of the first elastic body with a separation space: and a second inner surface in contact with the outer surface of the second member. The first elastic body further includes a first protrusion that extends inward from the first inner surface and is in contact with the second outer surface of the at least one second elastic body.

A sealing structure, according to an aspect of this disclosure, includes: a first member that has an opening; a second member that is stationary within the opening; and a sealing device that seals a gap between an inner peripheral surface of the opening in the first member and an outer surface of the second member. The sealing device includes: a first elastic body that includes: a first outer surface in contact with an inner peripheral surface of the opening in the first member; a first opening; and a first inner surface that defines the first opening; and at least one second elastic body located within the first opening and includes: a second outer surface that faces the first inner surface with a separation space: and a second inner surface in contact with the outer surface of the second member. The at least one second elastic body further includes a second protrusion that extends outward from the second outer surface and is in contact with the first inner surface of the first elastic body.

### BRIEF DESCRIPTION OF THE DRAWINGS

FIG. 1 is a perspective view of a sealing structure according to a first embodiment.
FIG. 2 is an exploded perspective view of the sealing structure.
FIG. 3 is a cross-sectional view of a first elastic body and second elastic bodies.
FIG. 4 is a cross-sectional view of the first elastic body and the second elastic bodies.
FIG. 5 is a cross-sectional view of the first elastic body in a non-secured state.
FIG. 6 is a cross-sectional view of one of the second elastic bodies in a non-secured state.
FIG. 7 is a cross-sectional view of the first elastic body and one of the second elastic bodies in a secured state.
FIG. 8 is a plan and section view of an elastic body according to a Comparative Example.
FIG. 9 is a cross-sectional view of a second elastic body according to a second embodiment.
FIG. 10 is a cross-sectional view of the first elastic body and one of the second elastic bodies in the secured state.
FIG. 11 is a perspective view of the sealing device according to a third embodiment.
FIG. 12 is a cross-sectional view of the second elastic bodies.
FIG. 13 is a cross-sectional view of the first elastic body according to a modification.
FIG. 14 is a cross-sectional view of a second elastic body according to another modification.
FIG. 15 is a cross-sectional view of the first elastic body according to yet another modification.

### DESCRIPTION OF THE EMBODIMENTS

Embodiments of this disclosure will be described with reference to the drawings. In the drawings, dimensions and scales of elements may differ from actual products. The following embodiments are examples of this disclosure, and thus the scope of this disclosure is not limited to the embodiments.

### A: First Embodiment

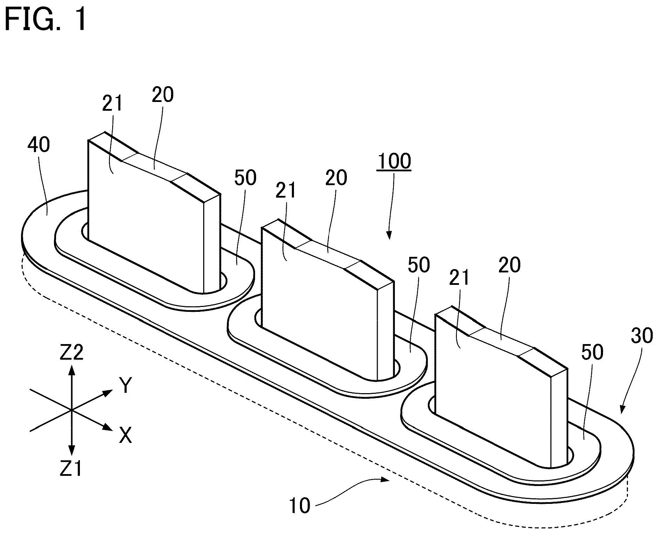

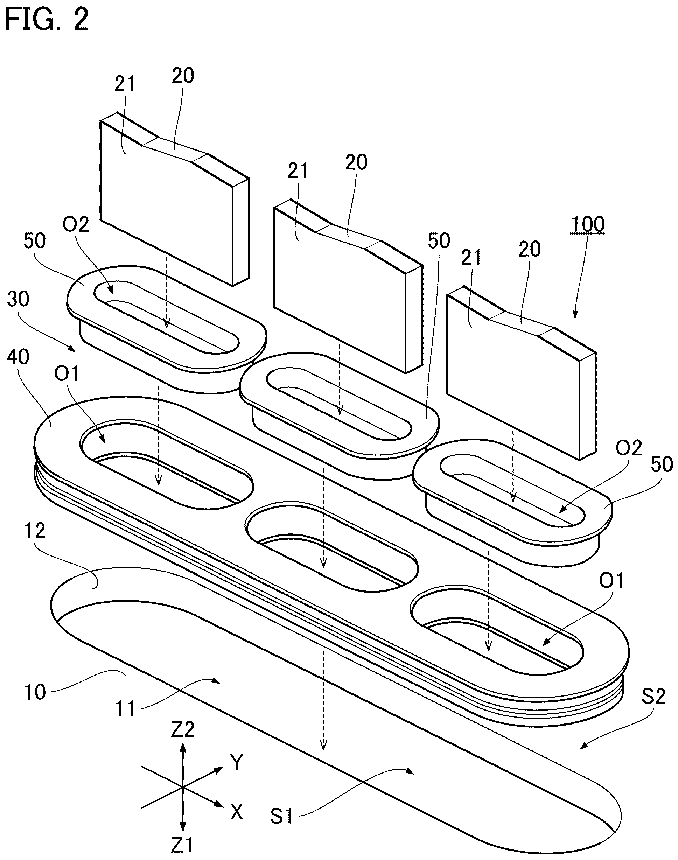

FIG. 1 is a perspective view of a sealing structure 100 according to a first embodiment. FIG. 2 is an exploded perspective view of the sealing structure 100. The sealing structure 100 is used in a power unit, such as an electric axle (e-Axle) of an electric vehicle. The scope of this disclosure can be changed as required.

Hereinafter, three orthogonal axes (X, Y, and Z-axes) are referenced. The Z-axis includes a negative direction Z1 (an example of "a first direction"), and a positive direction Z2 (an example of "a second direction") that is opposite to the negative direction Z1. The term "plan view" refers to a view taken along the Z-axis.

As shown in FIGS. 1 and 2, the sealing structure 100 includes a base 10, three wiring members 20 (e.g., busbars), and a sealing device 30. A housing mounted to an electric vehicle houses two or more components of the electric vehicle (e.g., electric motors, power convertors, and gears). The base 10 is a portion of the housing. The base 10 is a flat member oriented parallel to the X-Y plane and is made of, for example, a metal material. The base 10 is an example of a "first member."

The base 10 has an opening 11. The opening 11 extends in the thickness direction of the base 10. The opening 11 has an obround shape that extends along the X-axis. Specifically, the contour of the opening 11 has a pair of parallel opposing long edges and a pair of arcuate end portions that interconnect the long edges.

The base 10 partitions a first space S1 and a second space S2. The first space S1 is located below the base 10 in the negative direction Z1, and the second space is located above the base 10 in the positive direction Z2. The first space S1 is located inside the housing, and the second space S2 is located outside the housing. The first space S1 houses a drive device such as an electric motor or a power conversion device. The second space houses a control device for controlling or supplying power to the drive device housed in the second space S2. Heat generated by the drive device causes a temperature to increase in the first space S1, which may cause pressure fluctuations in the first space S1. Consequently, a pressure in the first space S1 may exceed a pressure in the second space S2.

The wiring members 20 are electrical conductors, and are made of low-resistance conductive materials, such as copper or a copper alloy. The wiring members 20 electrically connect the drive device in the first space S1 to the control device in the second space S2. In one example, the wiring members 20 are bus bars that transmit and receive three-phase AC power between the drive device and the control device. Here, the wiring members 20 are each an example of a "second member."

In the first embodiment, the wiring members 20 are each a flat elongate member. The wiring members 20 are arranged at intervals along the X-axis and pass through the opening 11 of the base 10. The wiring members 20 are stationary within the opening 11. Main surfaces of the wiring members 20, namely areas of the wiring members 20 other than their side surfaces, are aligned along the X-axis (i.e., the longitudinal direction of the opening 11).

The sealing device 30 seals a gap between an inner peripheral surface 12 of the opening 11 in the base 10 and outer surface 21 of the wiring members 20. The gap is sealed by the sealing device 30. Thus, the first space S1 is isolated from the second space S2. The sealing device 30 has a thickness direction that comprises the negative direction Z1 (the first direction) and the positive direction Z2 (the second direction).

In the first embodiment, the sealing device 30 includes a first elastic body 40 and three second elastic bodies 50. In one example, the first elastic body 40 is configured to be separate from the second elastic bodies 50, and each of the elastic bodies is individually molded by injection molding. The second elastic bodies 50 each have the same structure and are made of the same material. However, the structure or the material of one or more of the second elastic bodies 50 may differ.

The first elastic body 40 and the second elastic bodies 50 are made of an elastic material, such as a rubber material, and are elastically deformable. Examples of the rubber material of the first elastic body 40 and the second elastic bodies 50 include a variety of rubber materials, such as a chloroprene rubber (CR), a silicone rubber (SR), an acrylic rubber (ACM), an urethane rubber (UR), a polyurethane rubber (PUR), a vinyl methyl silicone rubber (VMQ), an ethylene propylene diene rubber (EPDM), and a fluororubber (FKM). Materials of the first elastic body 40 and the second elastic bodies 50 may be freely chosen.

In the first embodiment, the material of the first elastic body 40 differs from a material of the second elastic bodies 50. As a result, a hardness of the first elastic body 40 differs from a hardness of the second elastic bodies 50. Specifically, the second elastic bodies 50 each have a greater hardness than that of the first elastic body 40. In one example, a type A durometer hardness of the first elastic body 40 ranges from 40 to 80 degrees, but may be set at 40 degrees. A type A durometer hardness of the second elastic bodies 50 ranges from 40 to 90 degrees, but may be set at 50 degrees. In this example, the difference in hardness between the first elastic body 40 and the second elastic bodies 50 is due to use of different materials. However, if the same type of material is used for the first elastic body 40 and for the second elastic bodies 50, a hardness of the first elastic body 40 relative to that of the second elastic bodies 50 can be varied by be adjusting a ratio of components of the material.

The first elastic body 40 differs in volume resistivity from that of the second elastic bodies 50 due to the difference in the materials of the first elastic body 40 and the second elastic bodies 50. Volume resistivity is electrical resistance per unit volume. The second elastic bodies 50 each have a volume resistivity greater than that of the first elastic body 40. As a result, electrical current flowing through the second elastic bodies 50 is subject to greater resistance than electrical current flowing through the first elastic body 40. In this example, the difference in volume resistivity between the first elastic body 40 and the second elastic bodies 50 is due to the use of different materials. However, if the same material is used for the first elastic body 40 and for the second elastic bodies 50, a volume resistivity of the first elastic body 40 relative to that of the second elastic bodies 50 can be varied by adjusting a ratio of the components of the material.

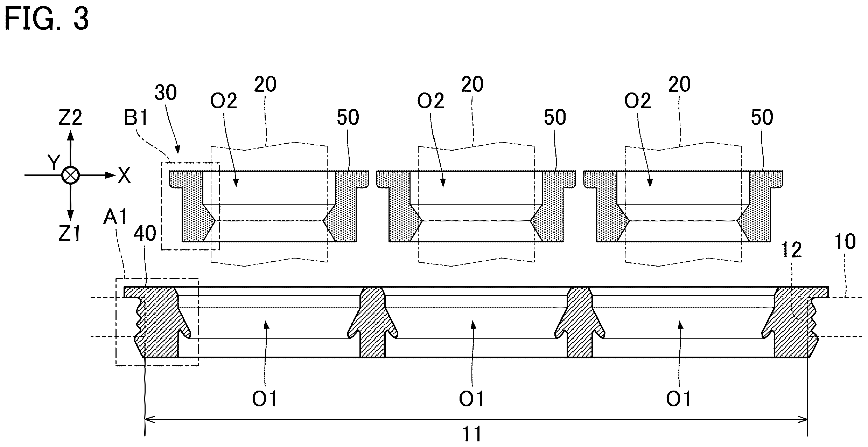

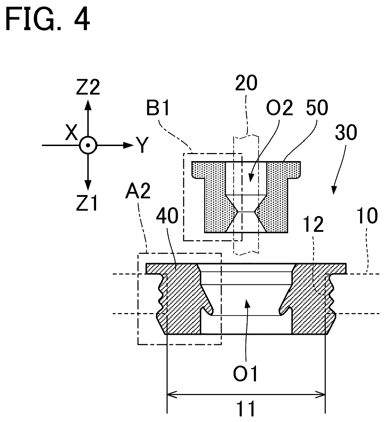

FIG. 3 is a cross-sectional view of the first elastic body 40 and the second elastic bodies 50 taken parallel to the X-Z plane. FIG. 4 is a cross-sectional view of the first elastic body 40 and one of the second elastic bodies 50 taken parallel to the Y-Z plane. In FIGS. 3 and 4, none of the second elastic bodies 50 is secured to the first elastic body 40.

As shown in FIGS. 1 through 4, the first elastic body 40 is secured to the opening 11 of the base 10. The first elastic body 40 has an obround shape that extends along the X-axis and matches the shape of the opening 11.

In one example, the first elastic body 40 has three first openings O1, each of which corresponds to one of the second elastic bodies 50. The first openings O1 are through-holes and are spaced apart at intervals along the X-axis and extend in the thickness direction of the first elastic body 40. The first openings O1 each have an obround shape that extends along the X-axis. Specifically, a contour of the first openings O1 has a pair of opposing parallel long edges and a pair of arcuate end portions that interconnect the long edges.

The second elastic bodies 50 are each secured to a corresponding one of the first openings O1, and each has an obround shape that extends along the X-axis and matches the shape of the first openings O1. The second elastic bodies 50 are arranged at intervals along the X-axis.

The second elastic bodies 50 each have second openings O2 that extend in the thickness direction of the second elastic bodies 50. The second openings O2 are through-holes. The second openings O2 each have an obround shape that extends along the X-axis. Specifically, a contour of the second openings O2 has a pair of opposing parallel long edges and a pair of arcuate end portions that interconnect the long edges. Each of the wiring members 20 passes through a corresponding one of the second openings O2 of the second elastic bodies 50, and is surrounded by the corresponding one of the second elastic bodies 50.

Hereinafter, the term "secured state" is a state in which (i) the first elastic body 40 is secured to the base 10, (ii) the wiring members 20 each pass through a corresponding one of the second elastic bodies 50, and (iii) the second elastic bodies 50 are secured to the first elastic body 40 together with the wiring members 20. Thus, in the secured state, the sealing structure 100 is assembled as a combination of the base 10, the wiring members 20, and the sealing device 30. In contrast, hereinafter the term "non-secured state" is a state in which (i) the first elastic body 40 is not secured to the base 10, (ii) the second elastic bodies 50 are not secured to the first elastic body 40, and (iii) the wiring members 20 do not each pass thorough the corresponding one of the second elastic bodies 50. Thus, in the non-secured state, the first elastic body 40 and the second elastic bodies 50 are separate.

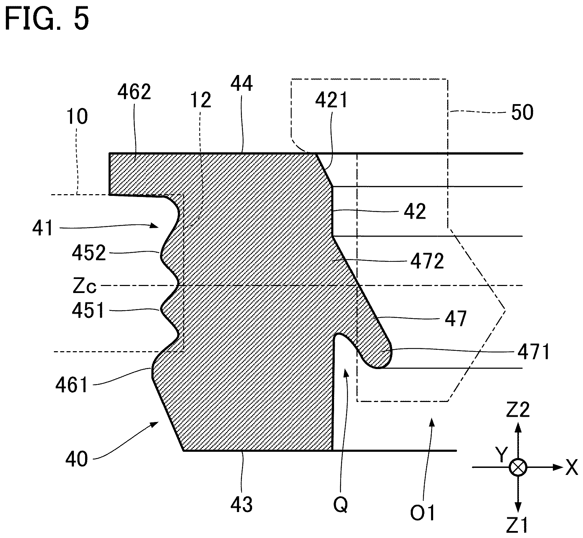

FIG. 5 is a cross-sectional view of the first elastic body 40 in the non-secured state. FIG. 5 depicts region A1 in FIG. 3/ region A2 in FIG. 4. Description will now be given of a configuration of the first elastic body 40 with reference to any one of the first openings O1.

As shown in FIG. 5, the first elastic body 40 has a first outer surface 41, a first inner surface 42, a bottom surface 43, and a top surface 44. The first outer surface 41 defines an outer peripheral surface of the first elastic body 40 and faces radially outward (away from the first opening O1). The first outer surface 41 is in contact with the inner peripheral surface 12 of the opening 11 in the base 10. The first inner surface 42 defines an inner peripheral surface of the first elastic body 40 and faces radially inward. The first inner surface 42 also defines the inner peripheral surface of the first opening O1. Hereinafter, the term "circumferential direction" is a direction along the inner circumference of the first opening O1 in the first elastic body 40 in plan view.

The bottom surface 43 defines a flat end surface of the first elastic body 40 oriented in the negative direction Z1. The top surface 44 defines a flat end surface of the first elastic body 40 oriented in the positive direction Z2. The first opening O1 extends along the Z-axis from the bottom surface 43 to the top surface 44.

As shown in FIG. 5, the first outer surface 41 includes a first outer peripheral protrusion 451 and a second outer peripheral protrusion 452, each of which extends radially outward and surrounds the entire circumference of the first elastic body 40. Further, the first and second outer peripheral protrusions 451 and 452 are spaced apart from each other in the thickness direction of the sealing device 30. The first outer peripheral protrusion 451 is located farther in the negative direction Z1 than the second outer peripheral protrusion 452.

The first elastic body 40 includes a first holding portion 461 and a second holding portion 462, each of which extends radially outward from the first outer surface 41. The first holding portion 461 and second holding portion and 462 each form a flange that extends and surrounds the entire circumference of the first elastic body 40.

The first holding portion 461 and the second holding portion 462 are arranged at intervals along the Z-axis. The first outer surface 41 (the first outer peripheral protrusion 451 and the second outer peripheral protrusion 452) is located between the first holding portion 461 and the second holding portion 462. Specifically, the first holding portion 461 is positioned downward (the negative direction Z1) on the first outer surface 41, and the second holding portion 462 is positioned upward (the positive direction Z2) on the same first outer surface 41. An upper surface (the positive direction Z2) of the second holding portion 462 lies on the same plane as the top surface 44 of the first elastic body 40.

The height of the first holding portion 461 and the height of the second holding portion 462 are each greater than the height of the first outer peripheral protrusion 451 and the height of the second outer peripheral protrusion 452. Specifically, the tops of the first holding portion 461 and the second holding portion 462 are located farther outward than the tops of the first outer peripheral protrusion 451 and the second outer peripheral protrusion 452. Further, the height of the first holding portion 461 is lesser than the height of the second holding portion 462. In other words, the top of the second holding portion 462 is located farther outward than the top of the first holding portion 461.

As shown in FIG. 5, the first outer surface 41, specifically, the first outer peripheral protrusion 451 and the second outer peripheral protrusion 452, is in contact with the inner peripheral surface 12 of the opening 11 in the base 10 with an interference fit. When the first outer surface 41 is in contact with the inner peripheral surface 12 of the opening 11, the inner edge of the base 10 is located between the first holding portion 461 and the second holding portion 462. Specifically, the inner edge of the base 10 includes a bottom corner located in the negative direction Z1, and a top corner located in the positive direction Z2. The bottom corner is in contact with the first holding portion 461, and the top corner of the base 10 is in contact with the second holding portion 462. Thus, the base 10 is clamped by first holding portion 461 and the second holding portion 462.

As described above, in the first embodiment, the first outer peripheral protrusion 451 and the second outer peripheral protrusion 452 of the first elastic body 40 are in contact with the inner peripheral surface 12 of the opening 11 in the base 10, thereby ensuring a secure seal between the base 10 and the first elastic body 40. Further, the inner peripheral surface 12 of the opening 11 in the base 10 is in contact with the first outer surface 41 (i.e., the first outer peripheral protrusion 451 and the second outer peripheral protrusion 452) of the first elastic body 40. In this state, the base 10 is located between first holding portion 461 and the second holding portion 462. As a result, axial displacement of the first elastic body 40 relative to the base 10 is suppressed.

The first elastic body 40 further includes a first protrusion 47. The first protrusion 47 extends radially inward from the first inner surface 42, and includes a distal end 471 and a proximal end 472. The first protrusion 47 is located at an axial center of the first inner surface 42 and extends around the entire circumference of the first elastic body 40.

As shown in FIG. 5, in the non-secured state, the first protrusion 47 is inclined obliquely outward and downward. Specifically, the first protrusion 47 is inclined relative to the Z-axis, and extends from the first inner surface 42 toward the negative direction Z1. Thus, the distal end 471 of the first protrusion 47 is located farther in the negative direction Z1 than the proximal end 472 of the first protrusion 47. Here, a central plane Zc as shown in FIG. 5 is an imaginary plane equidistant along the thickness direction of the sealing device 30 between the first outer peripheral protrusion 451 and second outer peripheral protrusion 452. The central plane Zc is an imaginary plane that intersects a midpoint between the top of the first outer peripheral protrusion 451 and the top of the second outer peripheral protrusion 452, and is perpendicular to the Z-axis (the thickness direction of the sealing device). The distal end 471 of the first protrusion 47 is located farther in the negative direction Z1 than the central plane Zc.

The first elastic body 40 further includes an inclined surface 421 on an end of the first inner surface 42 located in the positive direction Z2. The inclined surface 421 is inclined relative to the Z-axis (the thickness direction of the sealing device 30) such that its diameter increases in the positive direction Z2. Specifically, the inclined surface 421 has a smaller inner diameter at the end in the negative direction Z1 than at the end located in the positive direction Z2. Thus, the corner where the first inner surface 42 meets the top surface 44 is chamfered.

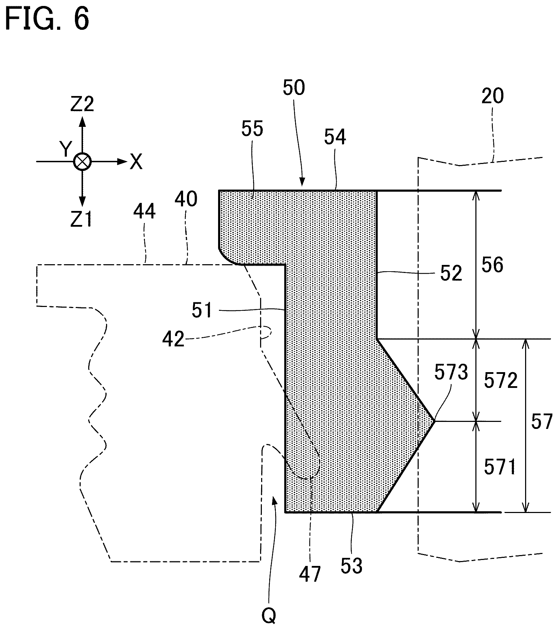

FIG. 6 is a cross-sectional view of the second elastic body 50 in the non-secured state. FIG. 6 depicts a region B1 in FIG. 3/ a region B2 in FIG. 4. The second elastic bodies 50 have the same structure, and thus description will now be given of a configuration of one of the second elastic bodies 50.

As shown in FIG. 6, the second elastic body 50 has a second outer surface 51, a second inner surface 52, a bottom surface 53, and a top surface 54. The bottom surface 53 defines a flat end surface oriented in the negative direction Z1, and the top surface 54 defines a flat end surface oriented in the positive direction Z2. The second opening O2 extends along the Z-axis between the bottom surface 53 and top surface 54. Hereinafter, the term "circumferential direction" is a direction along the inner circumference of the second opening O2 in the second elastic body 50 in plan view.

The second outer surface 51 defines an outer peripheral surface of the second elastic body 50 and faces radially outward (away from the second opening O2). The second outer surface 51 is flat and extends along the Z-axis. As shown in FIG. 6, the second outer surface 51 faces the first inner surface 42 of the first elastic body 40 with a separation space Q therebetween. The separation space Q is an annular space that surrounds the entire circumference of second elastic body 50.

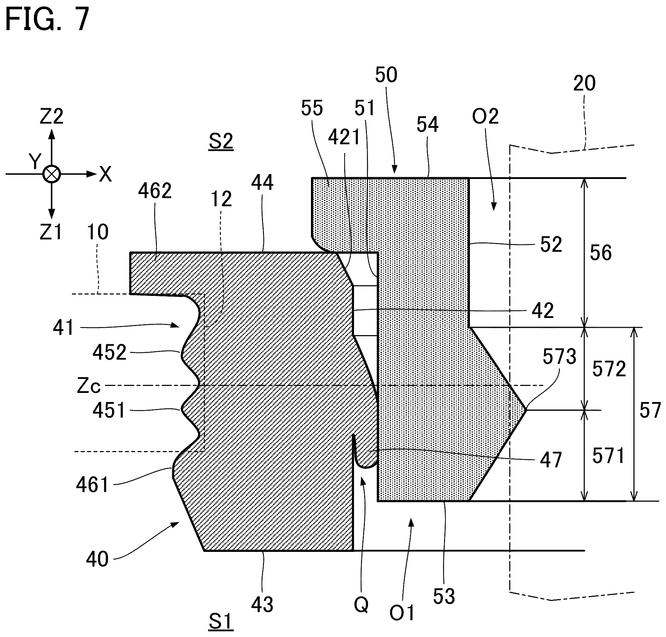

FIG. 7 is a cross-sectional view of the first elastic body 40 and one of the second elastic bodies 50 in the secured state. As shown in FIG. 7, the second elastic body 50 is secured to the first opening O1 of the first elastic body 40. In this state, the first protrusion 47 of the first elastic body 40 is in contact with the second outer surface 51 of the second elastic body 50. The first protrusion 47 is pressed radially outward (the negative direction of the X-axis) and deformed by the second outer surface 51 of the second elastic body 50. Specifically, in contrast to the non-secured state, the distal end 471 of the first protrusion 47 is displaced radially outward when pressed by the second outer surface 51. Thus, the first protrusion 47 is in contact with the second outer surface 51 of the second elastic body 50 with an interference fit.

As shown in FIG. 6, the second elastic body 50 further includes a third holding portion 55. The second elastic body 50 includes a top end and a bottom end. The top end is an end that includes the top surface 54 and is located in the positive direction Z2. The bottom end is an end that includes the bottom surface 53 and is located in the negative direction Z1. The third holding portion 55 extends radially outward from the second outer surface 51 and comprises a part of the top end. Specifically, the third holding portion 55 extends radially outward from an end of the second outer surface 51 located in the positive direction Z2. The third holding portion 55 forms a flange that extends around the entire circumference of the second elastic body 50.

In the secured state shown in FIG. 7, the third holding portion 55 is in contact with the top surface 44 of the first elastic body 40, thereby determining an axial position of the second elastic body 50 relative to the first elastic body 40. In this state, the bottom surface 43 of the first elastic body 40 is located farther in the negative direction Z1 than the bottom surface 53 of the second elastic body 50.

The second inner surface 52 of the second elastic body 50 defines an inner peripheral surface of the second elastic body 50 and faces radially inward. The second inner surface 52 also defines the inner peripheral surface of the second opening O2. The wiring member 20 passes through the second opening O2 of the second elastic body 50, and thus the second inner surface 52 is in contact with the outer surface 21 of the wiring member 20.

The second inner surface 52 includes a base area 56 that defines a flat surface and extends along the Z-axis, and an inner peripheral protrusion 57. The inner peripheral protrusion 57 is located below the base area 56, namely, is located farther in the negative direction Z1 than the base area 56. The inner peripheral protrusion 57 extends radially inward from the same level as the base area 56, and extends around the entire circumference of the second elastic body 50.

The inner peripheral protrusion 57 is disposed on the second inner surface 52 and has a first inclined surface 571 and a second inclined surface 572. The first inclined surface 571 is located below the second inclined surface 572; namely, is located farther in the negative direction Z1 than the second inclined surface 572. The second inclined surface 572 is located between the first inclined surface 571 and the base area 56 along the Z-axis. Specifically, the first inclined surface 571 is inclined relative to the Z-axis (the thickness direction of the sealing device 30) such that its diameter increases toward the negative direction Z1. The second inclined surface 572 is inclined relative to the Z-axis such that its diameter increases toward the positive direction Z2. The inner peripheral protrusion 57 includes a top 573, which forms an intersection of the first inclined surface 571 and the second inclined surface 572. As shown in FIG. 7, the top 573 of the inner peripheral protrusion 57 is located below the central plane Zc; namely, is located farther in the negative direction Z1 than the central plane Zc between the first outer peripheral protrusion 451 and the second outer peripheral protrusion 452.

The top 573 of the inner peripheral protrusion 57 comes into contact with the outer surface 21 of the wiring member 20. In the non-secured state, a planar dimension of the second opening O2 is less than that of the wiring member 20. As a result, the inner peripheral protrusion 57 of the second elastic body 50 comes into contact with the outer surface 21 of the wiring member 20 with an interference fit.

Description will now be given of a configuration of an assembled sealing structure 100. The first elastic body 40 is secured to the base 10, and the second elastic bodies 50 are secured to respective ones of the wiring members 20. Specifically, the first elastic body 40 is secured to the opening 11 in the base 10, and the wiring members 20 are fitted in respective second openings O2 corresponding to the second elastic bodies 50.

The second elastic bodies 50, in which each of the wiring members 20 is located, are secured to a respective one of the first openings O1 of the first elastic body 40. Specifically, the second elastic bodies 50 each pass through a corresponding one of the first openings O1 in the negative direction Z1, and are pressed until the third holding portion 55 comes into contact with the top surface 44 of the first elastic body 40. Thus, in the first embodiment, the first elastic body 40 includes the inclined surface 421 at the end of the first inner surface 42 located in the positive direction Z2. This configuration facilitates insertion of the second elastic bodies 50 into respective ones of the first openings O1 of the first elastic body 40.

As described above, in the first embodiment, the first outer surface 41 of the first elastic body 40 is in contact with the inner peripheral surface 12 of the opening 11 in the base 10, and the second inner surface 52 of each of the second elastic bodies 50 is in contact with the outer surface 21 of a corresponding wiring member 20. By this configuration, the first protrusion 47, which extends from the first inner surface 42 of the first elastic body 40, is in contact with the second outer surface 51 of each of the second elastic bodies 50. As a result, a gap between the inner peripheral surface 12 of the opening 11 in the base 10 and the outer surfaces 21 of the respective wiring members 20 is securely sealed.

Positions of the wiring members 20 relative to the base 10 may vary due to displacement along the X-Y plane. However, as shown in Fig. 7, in the first embodiment the first inner surface 42 of the first elastic body 40 faces the second outer surface 51 of each of the second elastic bodies 50 with a separation space Q between the two bodies. As a result, the separation space Q varies in response to positional changes between the base 10 and the wiring members 20. Variance in the separation space Q absorbs positional changes. As a result, the first elastic body 40 remains in constant contact with the base 10, and the second elastic bodies 50 each remain in constant contact with the corresponding one of the wiring members 20. When the separation space Q between the first elastic body 40 and the second elastic bodies 50 becomes sufficiently small, either the first elastic body 40 or the second elastic bodies 50 elastically deform. As a result, any relative positional change between the base 10 and the wiring members 20 is absorbed.

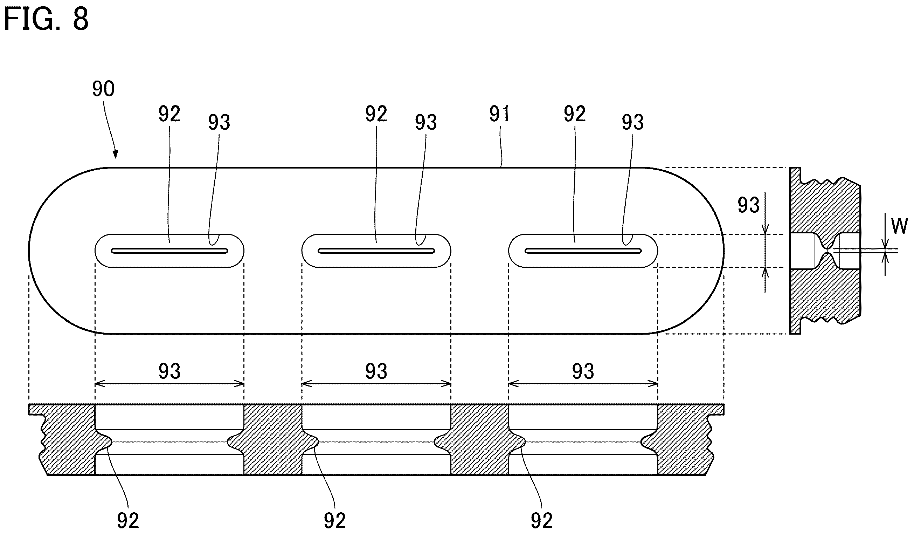

FIG. 8 is a plan and section view of an elastic body 90 according to a Comparative Example. In the Comparative Example, the elastic body 90 is provided. The elastic body 90 includes a main portion 91 and protrusions 92. The main portion 91 has an obround shape in plan view, and an outer peripheral surface that comes into contact with the inner peripheral surface 12 of the opening 11 in the base 10. The main portion 91 is provided with three obround openings 93. The protrusions 92 each extend radially inward from an inner peripheral surface of a corresponding one of the openings 93, and each defines an obround opening. The wiring members 20 pass through respective openings. As a result, the outer surface 21 of each of the wiring members 20 comes in contact with a corresponding one of the protrusions 92.

In the Comparative Example, any relative positional change between one of the wiring members 20 and the base 10 is absorbed by deformation of a corresponding one of the protrusions 92. To achieve this effect, it is necessary for a spacing W of the obround openings to be close together. Specifically, the spacing W should be smaller than the thickness of each of the wiring members 20. However, it is difficult to mold the elastic body 90 with such a small spacing W between the obround openings.

In the Comparative Example, the obround openings at each of the protrusions 92 are covered with a thin film, and a wiring member passes through the thin film into the openings. However, when the wiring member passes through the thin film, a small portion of the thin film is reputed, which may reduce a sealing performance of the sealing device 30.

In the first embodiment, as shown in FIG. 7, variations in the separation space Q between the first elastic body 40 and the second elastic bodies 50 absorb relative positional changes between the base 10 and the wiring members 20. Such a configuration eliminates a need for deformation of the inner peripheral protrusion 57 of the second elastic body 50 to absorb relative positional changes between the base 10 and the wiring members 20. As a result, the second openings O2 do not need to be excessively narrow. The molding process is easier than that in the Comparative Example. Further, provision of since the formation of the thin films, described in the Comparative Example, is unnecessary for the second elastic body 50, the sealing performance is preserved. According to the first embodiment, secure sealing of the gaps between the base 10 and the wiring members 20 is achieved without the need to excessively narrow the second openings O2 of the second elastic bodies 50.

According to the first embodiment, the material of the first elastic body 40 different to the material of the second elastic bodies 50. As a result, the first elastic body 40 can be formed from any suitable material in so far as it remains in contact with the inner peripheral surface 12 of the opening 11 in the base 10. Likewise, the second elastic bodies 50 can be formed from any suitable material in so far as they are remaining contact with each of the outer surface 21 of the wiring members 20. Second, the first elastic body 40 has a different hardness from the hardness of the second elastic bodies 50. As a result, the first elastic body 40 having an appropriate hardness can be formed as long as it is in contact with the inner peripheral surface 12 of the opening 11 in the base 10. Likewise, the second elastic bodies 50 having an appropriate hardness can be formed as long as they are in contact with the outer surface 21 of the respective wiring members 20.

Specifically, the second elastic bodies 50 each have a greater hardness the hardness of the first elastic body 40. As a result, positional changes between the base 10 and the wiring members 20 can be effectively absorbed, and the wiring members 20 are securely retained by the second elastic bodies 50. Further, the second elastic bodies 50, each of which is in contact with one of the wiring members 20, has a greater volume resistivity than the first elastic body 40. As a result, electrical interference around the wiring members 20 can be reduced. In particular, the possibility of a short circuit between the wiring member 20 and the base 10 can be reduced.

According to the first embodiment, as shown in FIG. 7, the first protrusion 47 of the first elastic body 40, which extends downward (in the negative direction Z1), is in contact with the second outer surface 51 of the second elastic body 50. As a result, when an air pressure in the first space S1 is greater than an air pressure in the second space S2, the gap between the base 10 and the wiring members 20 can be securely sealed. In particular, as shown in FIG. 5, the distal end 471 of the first protrusion 47 is located farther in the negative direction Z1 than the central plane Zc, which is located between the first and second outer peripheral protrusions 451 and 452. This arrangement reduces the possibility of displacement of the first inner surface 42 of the first elastic body 40 in the positive direction Z2 due to high air pressure in the first space S1, as compared to when the distal end 471 is located farther in the positive direction Z2 than the central plane Zc.

According to the first embodiment, as shown in FIG. 7, the inner peripheral protrusion 57 is located on the second inner surface 52 of the second elastic body 50 and is in contact with the outer surface 21 of the wiring member 20. This configuration effectively seals the gap between the inner peripheral surface 12 of the opening 11 in the base 10 and the outer surface 21 of the wiring member 20. In particular, the top 573 of the inner peripheral protrusion 57 is located farther in the negative direction Z1 than the central plane Zc. This configuration reduces deformation of the second elastic body 50 due to high pressure in the first space S1, as compared to when the top 573 is located farther in the positive direction Z2 than the central plane Zc.

### B: Second Embodiment

A second embodiment will now be described. In each of respective modifications exemplified below, elements that are substantially the same as those described in the first embodiment are denoted by like reference signs, and detailed explanation thereof is omitted as appropriate.

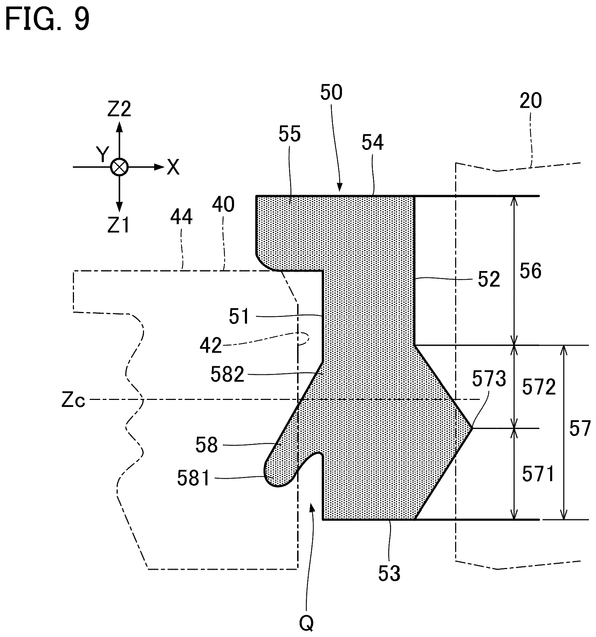

FIG. 9 is a cross-sectional view of the second elastic body 50 according to the second embodiment. As shown in FIG. 9, the second elastic body 50 further includes a second protrusion 58. The second protrusion 58 extends radially outward from the second outer surface 51, and includes a distal end 581 and a proximal end 582. Further, the second protrusion 58 is located at the axial center of the second outer surface 51 and extends around the full circumference of the second elastic body 50.

As shown in FIG. 9, in the non-secured state, the second protrusion 58 is inclined obliquely outward and downward. Specifically, the second protrusion 58 is inclined relative to the Z-axis, extending from the second outer surface 51 toward the negative direction Z1. Thus, the distal end 581 of the second protrusion 58 is located farther in the negative direction Z1 than the proximal end 582 of the second protrusion 58. Here, FIG.9 also shows the same central plane Zc, which is an imaginary surface equidistant along the thickness direction of the sealing device 30 between the first and second outer peripheral protrusions 451 and 452. The distal end 581 of the second protrusion 58 is located farther in the negative direction Z1 than the central plane Zc.

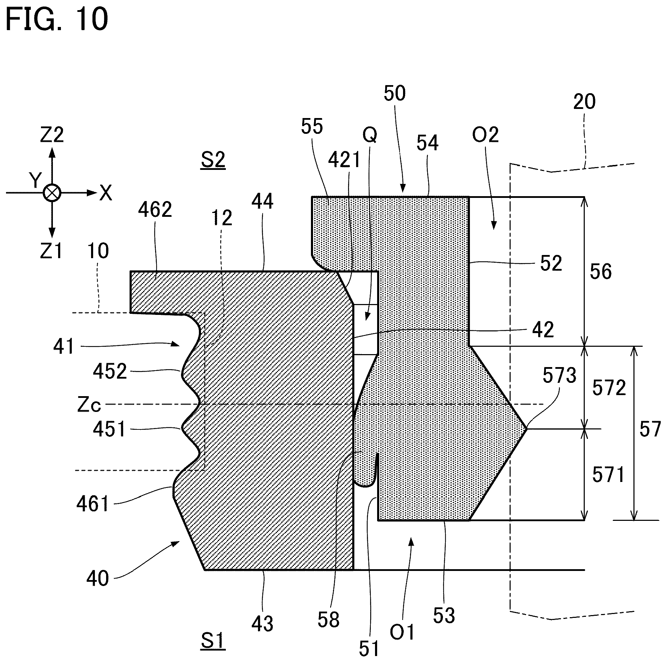

FIG. 10 is a cross-sectional view of the first elastic body 40 and one of the second elastic bodies 50 in the secured state. As shown in FIG. 10, the first inner surface 42 of the first elastic body 40 is flat and extends along the Z-axis. In this embodiment, there is no first protrusion 47 on the first inner surface 42.

As shown in FIG. 10, the second elastic body 50 is secured to the first opening O1 of the first elastic body 40. In this state, the second protrusion 58 of the second elastic body 50 is in contact with the first inner surface 42 of the first elastic body 40. The second protrusion 58 is pressed radially inward and deformed by the first inner surface 42 of the first elastic body 40. Specifically, the distal end 581 of the second protrusion 58 is displaced radially inward when pressed by the second inner surface 52, compared to the non-secured state. Thus, the second protrusion 58 is in contact with the first inner surface 42 of the first elastic body 40 with an interference fit. This embodiment corresponds to the first embodiment, except that the first protrusion 47 of the first elastic body 40 is replaced with the second protrusion 58 of the second elastic body 50.

According to the second embodiment, as shown in FIG. 10, the first outer surface 41 of the first elastic body 40 is in contact with the inner peripheral surface 12 of the opening 11 in the base 10, and the second inner surface 52 of each second elastic body 50 is in contact with the outer surface 21 of the corresponding wiring member 20. In this configuration, the second protrusion 58, which extends from the second outer surface 51 of the second elastic body 50, is in contact with the first inner surface 42 of the first elastic body 40, thereby sealing the gap between the inner peripheral surface 12 of the opening 11 in the base 10 and the outer surface 21 of each of the wiring members 20.

Similarly to the first embodiment, in the second embodiment, as shown in FIG. 10, the first inner surface 42 of the first elastic body 40 faces the second outer surface 51 of the second elastic body 50 with a separation space Q between the two bodies. The separation space Q varies in response to positional changes between the base 10 and the wiring member 20. This variation in the separation space Q absorbs the positional changes between the base 10 and the wiring members 20. This variation in the separation space Q absorbs the relative positional changes between the base 10 and the wiring member 20. The aforementioned second embodiment provides the same advantages as the first embodiment, namely, secure sealing of the gaps between the base 10 and the wiring members 20 is achieved without the need to excessively narrow the second openings O2 of the second elastic bodies 50.

Furthermore, as shown in FIG. 10, the second protrusion 58, which extends in the negative direction Z1, is in contact with the first inner surface 42 of the first elastic body 40. As a result, when the air pressure in the first space S1 exceeds that in the second space S2, the space between the base 10 and the wiring member 20 can be securely sealed. In particular, the distal end 581 of the second protrusion 58 is located farther in the negative direction Z1 than the central plane Zc, which is located between the first and second outer peripheral protrusions 451 and 452. This arrangement reduces the possibility of displacement of the second outer surface 51 of the second elastic body 50 in the positive direction Z2 due to high air pressure in the first space S1, as compared to when the distal end 581 of the second protrusion 58 is located farther in the positive direction Z2 than the central plane Zc.

### C: Third Embodiment

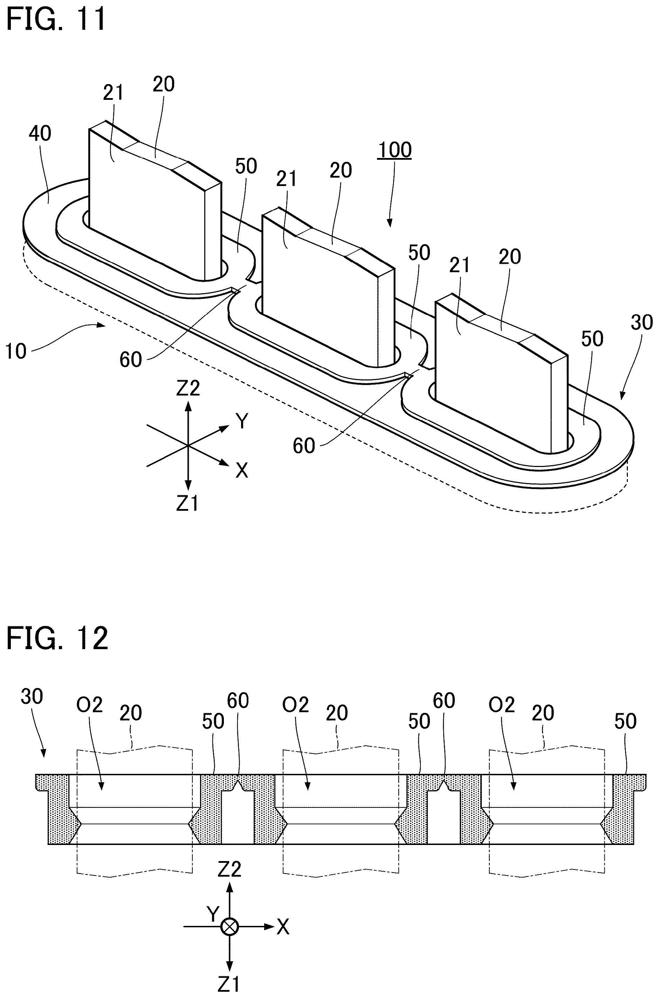

FIG. 11 is a perspective view of the sealing device 30 according to a third embodiment. FIG. 12 is a cross-sectional view of the second elastic bodies 50. In the first embodiment, the second elastic bodies 50 are each an independent component. In contrast, in the third embodiment shown in FIGs. 11 and 12, for example, three elastic bodies 50 are interconnected. The configurations of the first and second elastic bodies 40 and 50 remain the same as in the first embodiment.

Specifically, two adjacent second elastic bodies 50 are interconnected via a connector 60 along the X-axis. The three second elastic bodies 50 and the two connectors 60 are integrally molded by injection molding. In the secured condition, the connectors 60 are located on the bottom surface 43 (the end surface in the positive direction Z2) of the first elastic body 40.

The third embodiment provides the same effects as those of the first embodiment. Further, the second elastic bodies 50 are interconnected. As a result, handling is easier, compared to when the second elastic bodies 50 are each independent components, as described in the first and second embodiments. The manufacturing cost can be minimized by decreasing the number of parts of the sealing device 30. It is of note that the sealing device 30 and the second elastic bodies 50 described above are based on those described in the first embodiment. However, the interconnected second elastic bodies 50 may be applied to the second embodiment in which the second elastic bodes 50 each include the second protrusion 58.

### D: Modifications

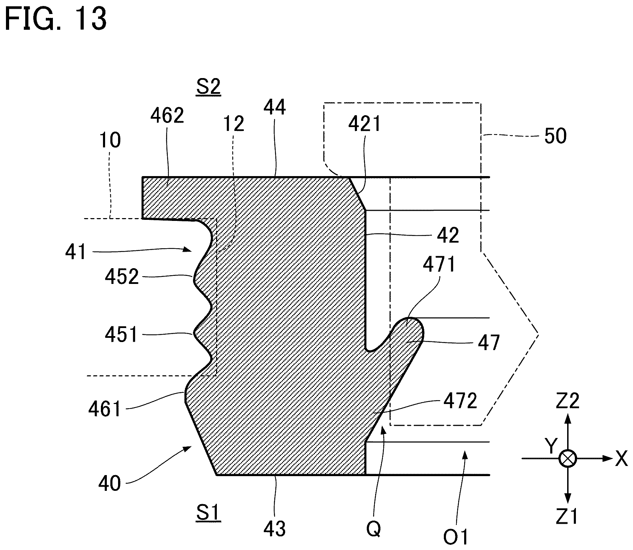

Specific modifications of the foregoing embodiments are described below. Two or more modifications may be combined with each other in so far as such combination does not give rise to any contradiction.
(1) When the air pressure in the first space S1 is greater that the air pressure in the second space S2, as shown in FIG. 5 of the first embodiment, it is preferred that the first protrusion 47 extend radially inward and downward (in the negative direction Z1). Conversely, when the air pressure in the second space S2 exceeds that in the first space S1, as shown in FIG. 13, the first protrusion 47 may extend upward from the first inner surface 42 of the first elastic body 40 (in the positive direction Z2). As shown in FIG. 13, the first protrusion 47 extends radially inward and upward. Specifically, the distal end 471 thereof is located farther in the positive direction Z2 than the proximal end 472.

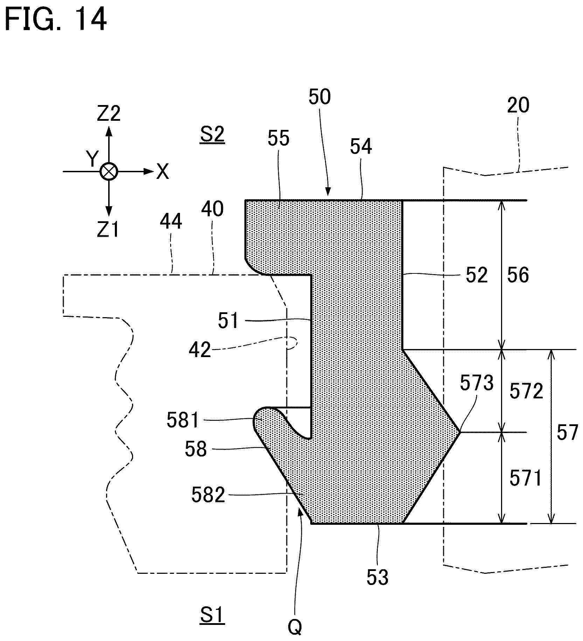

In the second embodiment, as shown in FIG. 9, the second protrusion 58 extends radially outward and downward (in the negative direction Z1). When the air pressure in the second space S2 is greater than the air pressure in the first space S1, as shown in in FIG. 14, the second protrusion 58 may extend radially outward and upward. Specifically, the second protrusion 58 may extend from the second outer surface 51 of the second elastic body 50 in the positive direction Z2. As shown in FIG. 14, the distal end 581 of the second protrusion 58 is located farther in the positive direction Z2 than the proximal end 582 of the second protrusion 58.

(2) In the foregoing embodiments, the material of the first elastic body 40 is different from the material of the second elastic bodies 50. However, the material of first elastic body 40 may be the same as the material of the second elastic bodies 50. In such a case, the first and second elastic bodies 40 and 50 may exhibit the same characteristics, such as hardness and volume resistivity. When the same material is employed, the manufacturing cost of the first and second elastic bodies 40 and 50 is minimized, compared to when different materials are employed, as described in the first to third embodiments.

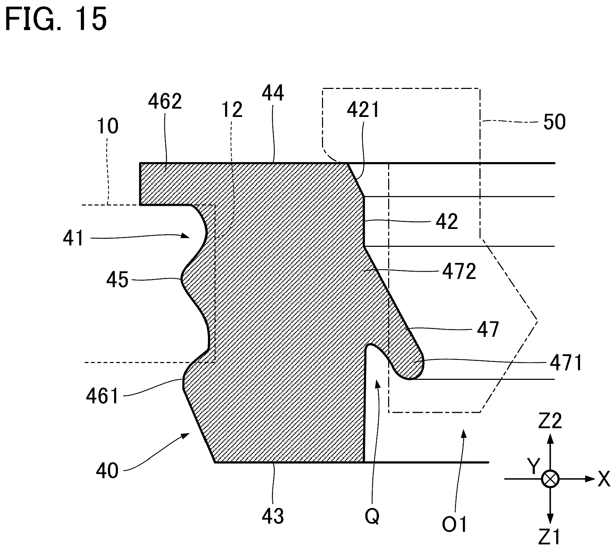

(3) In the foregoing embodiments, the first outer surface 41 of the first elastic body 40 includes two outer peripheral protrusions 45 (451 and 452). However, the number of the outer peripheral protrusions on the first outer surface 41 may be freely selected. For example, as shown in FIG. 15, the first outer surface 41 may include a single outer peripheral protrusion 45. Alternatively, the first outer surface 41 may include three or more outer peripheral protrusions 45 at intervals along the Z-axis. Thus, in one aspect of this disclosure, the first outer surface 41 of the first elastic body 40 includes at least one outer peripheral protrusion 45. Alternatively, the outer peripheral protrusion 45 may be omitted in so far as reliable sealing is maintained between the inner peripheral surface 12 of the opening 11 in the base 10 and the first outer surface 41 of the first elastic body 40.

(4) In the foregoing embodiments, the three second elastic bodies 50 are secured to the first elastic body 40. However, a ratio between the number of the first elastic bodies 40 and the number of the second elastic bodies 50 may be freely selected. Specifically, a single second elastic body 50 may be secured to a single first elastic body 40. Alternatively, two or four or more second elastic bodies 50 may be secured to a single first elastic body 40.

(5) In the foregoing embodiments, the sealing device 30 seals the space between base 10 of the housing, which is mounted to the electric vehicle, and the wiring members 20 pass through the opening 11 of the base 10. However, the sealing device 30 is not limited to sealing only this space. Here, the base 10 is an example of a "first member," and the wiring member 20 is an example of a "second member" located within the opening of the first member.

In the foregoing embodiments, the wiring members 20 are stationary within the opening 11 of the base 10. Alternatively, the second member may be a shaft (axial member) rotatable about its rotation axis, or a shaft that swings relative to the Z-axis.

(6) The notation "n-th" (n is a natural number) in this disclosure is used only as a formal and convenient label to distinguish elements in the notation, and carries no substantive meaning. Accordingly, the notation "n-th" should not be constructed as limiting the position of each element, the order of manufacture, or similar aspects.

### E: Appendices

The following example configurations are derivable from the foregoing embodiments.

A sealing device, according to an aspect (Aspect 1) of this disclosure, seals a gap between an inner peripheral surface of an opening in a first member and an outer surface of a second member that is stationary within the opening. The sealing device includes: a first elastic body that includes: a first outer surface in contact with an inner peripheral surface of the opening in the first member; a first opening; and a first inner surface that defines the first opening; and at least one second elastic body that is located within the first opening of the first elastic body and includes: a second outer surface that faces the first inner surface of the first elastic body with a separation space: and a second inner surface in contact with the outer surface of the second member. The first elastic body further includes a first protrusion that extends inward from the first inner surface and is in contact with the second outer surface of the at least one second elastic body.

In this aspect, the first outer surface of the first elastic body is in contact with the inner peripheral surface of the opening in the first member, and the second inner surface of the second elastic body is in contact with the surface of the second member. In this configuration, the first protrusion, which extends from the first inner surface of the first elastic body, is in contact with the second outer surface of the second elastic body, thereby sealing the gap between the inner peripheral surface of the opening in the first member and the surface of the second member.

Further, the first inner surface of the first elastic body faces the second outer surface of the second elastic body with a separation space between the two bodies. The separation space changes; however, even if the relative position between the first and second members varies, the first elastic body remains in contact with the first member, and the second elastic body remains in contact with the second member. As a result, secure sealing of the gap between the first and second members is achieved without the need to excessively narrow the second opening in the second elastic body.

The sealing device, according to another aspect (Aspect 2) of this disclosure, seals a gap between an inner surface of an opening in a first member and an outer surface of a second member that is stationary within the opening. The sealing device includes: a first elastic body that includes: a first outer surface in contact with an inner peripheral surface of the opening in the first member; a first opening; and a first inner surface that defines the first opening; and at least one second elastic body that is located within the first opening and includes: a second outer surface that faces the first inner surface of the first elastic body with a separation space: and a second inner surface in contact with the outer surface of the second member. The at least one second elastic body further includes a second protrusion that extends outward from the second outer surface and is in contact with the first inner surface of the first elastic body.

In this aspect, the first outer surface of the first elastic body is in contact with the inner peripheral surface of the opening disposed in the first member, and the second inner surface of the second elastic body is in contact with the surface of the second member. In this configuration, the second protrusion, which extends from the second outer surface of the second elastic body, is in contact with the first inner surface of the first elastic body, thereby sealing the gap between the inner peripheral surface of the opening disposed in the first member and the surface of the second member.

Further, the first inner surface of the first elastic body faces the second outer surface of the second elastic body with a separation space between the two bodies. The separation space changes; however, even if the relative position between the first and second members varies, the first elastic body remains in contact with the first member, and the second elastic body remains in contact with the second member. As a result, secure sealing of the gap between the first and second members is achieved without the need to excessively narrow the second opening of the second elastic member.

In an example (Aspect 3) according to Aspect 1 or 2, the first elastic body is made of a different material from a material of the at least one second elastic body.

In this aspect, the first elastic body can be made of a suitable material in so far as it is remains in contact with the inner peripheral surface of the opening disposed in the first member. Likewise, the second elastic body can be formed from a suitable material in so far as it remains in contact with the surface of the second member.

In an example (Aspect 4) according to Aspect 1 or 2, the first elastic body is made of a same material as the material of the at least one second elastic body.

In this aspect, the manufacturing cost of the first and second elastic bodies can be minimized.

In an example (Aspect 5) according to any one of Aspects 1 to 4, the first elastic body has a different hardness from a hardness of the at least one second elastic body.

In this aspect, the first elastic body having an appropriate hardness can be formed as long as it is in contact with the inner peripheral surface of the opening disposed in the first member. Likewise, the second elastic body having an appropriate hardness can be formed in so far as it remains in contact with the surface of the second member.

In an example (Aspect 6) according to Aspect 5, the at least one second elastic body has a greater hardness than the hardness of the first elastic body.

In this aspect, the second elastic body has a greater hardness than a hardness of the first elastic body. As a result, positional changes between the first and second members can be effectively absorbed, and the second member is securely retained by the second elastic body.

In an example (Aspect 7) according to any one of aspects 1 to 6, the second member is an electrical conductor, and the at least one second elastic body has a greater volume resistivity than a volume resistivity of the first elastic body.

In this aspect, the second elastic body, which is in contact with the conductive second member, has a greater volume resistivity than the first elastic body. As a result, electrical interference around the second member can be reduced.

In an example (Aspect 8) according to any one of Aspects 1 to 7, the first elastic body further includes a first holding portion and a second holding portion, each of which extends outward from the first outer surface. The first outer surface is located between the first holding portion and the second holding portion. The first member includes an inner edge located along the opening, and the inner edge is located between the first holding portion and the second holding portion.

In this aspect, the inner peripheral surface of the opening disposed in the first member is in contact with the outer surface of the first elastic body. In this state, the first member is located between the first holding portion and second holding portion. As a result, axial displacement of the first elastic body relative to the first member can be suppressed.

In an example (Aspect 9) according to any one of Aspects 1 to 8, the first outer surface of the first elastic body includes at least one outer peripheral protrusion that extends circumferentially around the first elastic body.

In this aspect, at least one outer peripheral protrusion is in contact with the inner peripheral surface of the opening disposed in the first member, thereby ensuring a secure seal between the first member and the first elastic body.

In an example (Aspect 10) of Aspect 1, the first protrusion of the first elastic body includes a distal end and a proximal end. The sealing device has a thickness direction that includes a first direction. The distal end is located farther in the first direction than the proximal end.

In this aspect, the first protrusion of the first elastic body, which extends in the first direction, is in contact with the second outer surface of the second elastic body. As a result, when an air pressure in a first space, which is located in the first direction of the sealing device, is greater than an air pressure in a second space, which is located in the second direction that opposes the first direction, the gap between the first and second members can be securely sealed.

In an example (Aspect 11) according to Aspect 10, the first outer surface of the first elastic body includes a first outer peripheral protrusion and a second outer peripheral protrusion, each of which extends outward and circumferentially around the first elastic body. The first and second outer peripheral protrusions are spaced apart from each other in the thickness direction of the sealing device. The distal end of the first protrusion is located farther in the first direction than a central plane. The central plane is an imaginary plane equidistant along the thickness direction of the sealing device between the first outer peripheral protrusion and the second outer peripheral protrusion.

In this aspect, the distal end of the first protrusion is located farther in the first direction than the central plane. This arrangement reduces the possibility of displacement of the first inner surface of the first elastic body in the second direction due to high air pressure in the first space, as compared to when the distal end is located farther in the second direction than the central plane.

In an example (Aspect 12) according to Aspect 2, the second protrusion of the at least one second elastic body includes a distal end and a proximal end. The sealing device has a thickness direction that includes a first direction. The distal end is located farther in the first direction than the proximal end.

In this aspect, the second protrusion, which extends in the first direction, is in contact with the first inner surface of the first elastic body. As a result, when the air pressure in the first space, which is located in the first direction of the sealing device, is greater than an air pressure in the second space, which is located in the second direction, the gap between the first and second members can be securely sealed.

In an example (Aspect 13) according to Aspect 12, the first outer surface of the first elastic body includes a first outer peripheral protrusion and a second outer peripheral protrusion, each of which extends outward and circumferentially around the first elastic body. The first outer peripheral protrusion and the second outer peripheral protrusion are spaced apart from each other in the thickness direction of the sealing device. The distal end of the second protrusion is located farther in the first direction than a central plane. The central plane is an imaginary plane equidistant along the thickness direction of the sealing device between the first outer peripheral protrusion and second outer peripheral protrusion.

In this aspect, the distal end of the second protrusion is located farther in the first direction than the central plane. This arrangement reduces a possibility of displacement of the second inner surface of the second elastic body in the second direction due to high air pressure in the first space, as compared to when the distal end is located farther in the second direction than the central plane.

In an example (Aspect 14) according to aspect 11 or 13, the second inner surface of the at least one second elastic body includes an inner peripheral protrusion that extends circumferentially around the at least one second elastic body. The inner peripheral protrusion includes a top located farther in the first direction than the central plane.

In this aspect, the inner peripheral protrusion is located on the second inner surface of the second elastic body and is in contact with the surface of the second member. This configuration effectively seals the gap between the inner peripheral surface of the opening disposed in the first member and the surface of the wiring member. Further, the top of the inner peripheral protrusion is located farther in the first direction than the central plane. This configuration reduces deformation of the second elastic body due to high pressure in the first space, as compared to when the top is located farther in the second direction than the central plane.

In an example (Aspect 15) according to any one of Aspects 1 to 14, the at least one second elastic body further includes a third holding portion that extends circumferentially around the at least one second elastic body. The sealing device has a thickness direction that includes a second direction. The third holding portion extends outward from an end of the second outer surface located in the second direction. The first elastic body further includes an inclined surface disposed on an end of the first inner surface that is located in the second direction, and the inclined surface is inclined such that its diameter thereof increases in the second direction.

In the above aspect, the first elastic body further includes the inclined surface disposed on the end of the first inner surface that is located in the second direction. This configuration facilitates the insertion of the second elastic body into the first opening of the first elastic body. When the third holding portion of the second elastic body comes into contact with the surface of the first elastic body, the axial position of the second elastic body is determined.

In an example (Aspect 16) according to any one of Aspects 1 to 15, the at least one second elastic body includes a plurality of second elastic bodies. The first elastic body includes a plurality of first openings including the first opening. The plurality of second elastic bodies are secured to the respective first openings and are interconnected.

In this aspect, the second elastic bodies are secured to respective ones of the first openings. As a result, when the second elastic bodies are provided in the opening of the first member, the gap between the inner peripheral surface of the opening in the first member and the surface of each second member can be sealed. Further, the second elastic bodies are interconnected. As a result, handling is easier, compared to when the second elastic bodies are each an independent component.

A sealing structure, according to one aspect (Aspect 17) of this disclosure, includes: a first member that has an opening; a second member that is stationary within the opening; and a sealing device that seals a gap between an inner peripheral surface of the opening in the first member and an outer surface of the second member. The sealing device includes: a first elastic body that includes: a first outer surface in contact with an inner peripheral surface of the opening in the first member; a first opening; and a first inner surface that defines the first opening; and at least one second elastic body that is located within the first opening of the first elastic body and includes: a second outer surface that faces the first inner surface of the first elastic body with a separation space: and a second inner surface in contact with the outer surface of the second member. The first elastic body further includes a first protrusion that extends inward from the first inner surface and is in contact with the second outer surface of the at least one second elastic body.

A sealing structure, according to one aspect (Aspect 18) of this disclosure, includes: a first member that has an opening; a second member that is stationary within the opening; and a sealing device that seals a gap between an inner peripheral surface of the opening in the first member and an outer surface of the second member. The sealing device includes: a first elastic body that includes: a first outer surface in contact with an inner peripheral surface of the opening in the first member; a first opening; and a first inner surface that defines the first opening; and at least one second elastic body located within the first opening and includes: a second outer surface that faces the first inner surface with a separation space: and a second inner surface in contact with the outer surface of the second member. The at least one second elastic body further includes a second protrusion that extends outward from the second outer surface and is in contact with the first inner surface of the first elastic body.

### Description of Reference Signs

100... sealing structure, 10... base, 11... opening, 12... inner peripheral surface, 20... wiring member, 21... surface, 30... sealing device, 40... first elastic body, 41... first outer surface, 42... first inner surface, 421... inclined surface, 43... bottom surface, 44... top surface, 451... first outer peripheral protrusion, 452... second outer peripheral protrusion, 461... first holding portion 462... second holding portion, 47... first protrusion, 471... distal end, 472... proximal end, 50... second elastic body, 51... second outer surface, 52... second inner surface, 53... bottom surface, 54... top surface, 55... third holding portion, 56... base area, 57... inner peripheral protrusion, 571... first inclined surface, 572... second inclined surface, 573... top, 58... second protrusion, 581... distal end, 582... proximal end, O1... first opening, O2... second opening.

## Claims

1. A sealing device that seals a gap between an inner peripheral surface of an opening in a first member and an outer surface of a second member that is stationary within the opening, the sealing device comprising:
a first elastic body that includes:
a first outer surface in contact with an inner peripheral surface of the opening in the first member;
a first opening; and
a first inner surface that defines the first opening; and
at least one second elastic body that is located within the first opening of the first elastic body and includes:
a second outer surface that faces the first inner surface of the first elastic body with a separation space; and
a second inner surface in contact with the outer surface of the second member,
wherein the first elastic body further includes a first protrusion that extends inward from the first inner surface and is in contact with the second outer surface of the at least one second elastic body.

2. The sealing device according to claim 1,
wherein the first elastic body is made of a different material from a material of the at least one second elastic body.

3. The sealing device according to claim 1,
wherein the first elastic body is made of a same material as the material of the at least one second elastic body.

4. The sealing device according to claim 1,
wherein the first elastic body has a different hardness from a hardness of the at least one second elastic body.

5. The sealing device according to claim 4,
wherein the at least one second elastic body has a greater hardness than the hardness of the first elastic body.

6. The sealing device according to claim 1, wherein:
the second member is an electrical conductor, and
the at least one second elastic body has a greater volume resistivity than a volume resistivity of the first elastic body.

7. The sealing device according to claim 1, wherein:
the first elastic body further includes a first holding portion and a second holding portion, each of which extends outward from the first outer surface,
the first outer surface is located between the first holding portion and the second holding portion, and
the first member includes an inner edge located along the opening, and the inner edge is located between the first holding portion and the second holding portion.

8. The sealing device according to claim 1,
wherein the first outer surface of the first elastic body includes at least one outer peripheral protrusion that extends circumferentially around the first elastic body.

9. The sealing device according to claim 1, wherein:
the first protrusion of the first elastic body includes a distal end and a proximal end,
the sealing device has a thickness direction that includes a first direction, and
the distal end is located farther in the first direction than the proximal end.

10. The sealing device according to claim 9, wherein:
the first outer surface of the first elastic body includes a first outer peripheral protrusion and a second outer peripheral protrusion, each of which extends outward and circumferentially around the first elastic body,
the first and second outer peripheral protrusions are spaced apart from each other in the thickness direction of the sealing device, and
the distal end of the first protrusion is located farther in the first direction than a central plane, the central plane being an imaginary plane equidistant along the thickness direction of the sealing device between the first outer peripheral protrusion and the second outer peripheral protrusion.

11. The sealing device according to claim 10, wherein:
the second inner surface of the at least one second elastic body includes an inner peripheral protrusion that extends circumferentially around the at least one second elastic body,
the inner peripheral protrusion includes a top located farther in the first direction than the central plane.

12. The sealing device according to claim 1, wherein:
the at least one second elastic body further includes a third holding portion that extends circumferentially around the at least one second elastic body,
the sealing device has a thickness direction that includes a second direction,
the third holding portion extends outward from an end of the second outer surface located in the second direction, and
the first elastic body further includes an inclined surface disposed on an end of the first inner surface that is located in the second direction, and the inclined surface is inclined such that its diameter thereof increases in the second direction.

13. The sealing device according to claim 1, wherein:
the at least one second elastic body comprises a plurality of second elastic bodies,
the first elastic body includes a plurality of first openings including the first opening,
the plurality of second elastic bodies are secured to the respective first openings and are interconnected.

14. A sealing structure comprising:
a first member that has an opening;
a second member that is stationary within the opening; and
a sealing device that seals a gap between an inner peripheral surface of the opening in the first member and an outer surface of the second member, wherein:
the sealing device comprises:
a first elastic body that includes:
a first outer surface in contact with an inner peripheral surface of the opening in the first member;
a first opening; and
a first inner surface that defines the first opening; and
at least one second elastic body that is located within the first opening of the first elastic body and includes:
a second outer surface that faces the first inner surface of the first elastic body with a separation space; and
a second inner surface in contact with the outer surface of the second member, and
the first elastic body further includes a first protrusion that extends inward from the first inner surface and is in contact with the second outer surface of the at least one second elastic body.
